# EUROPEAN PATENT APPLICATION

(11) **EP 2 922 109 A1**
(43) Date of publication of application: **23.09.2015**
(21) Application number: 13854418.4
(22) Date of filing: 29.10.2013
(51) Int. Cl.: H01L 51/42

(54) **SOLAR CELL**

(30) Priority: 13.11.2012 JP 2012249561; 18.03.2013 JP 2013055362
(71) Applicant: Sekisui Chemical Co., Ltd., Osaka-shi, Osaka 530-0047 (JP)
(72) Inventor: OHARA, Shunji, Mishima-gun Osaka 618-0021 (JP); HAYAKAWA, Akinobu, Mishima-gun Osaka 618-0021 (JP); HORIKI, Mayumi, Mishima-gun Osaka 618-0021 (JP); ITO, Kazushi, Mishima-gun Osaka 618-0021 (JP)
(74) Representative: Hart-Davis, Jason
(86) International application number: PCT/JP2013/079243
(87) International publication number: WO 2014/077121

(57) **Abstract**

It is an object of the present invention to provide a solar cell capable of exhibiting excellent photoelectric conversion efficiency even when ultraviolet light is blocked. The present invention relates to a solar cell including: a cathode; an anode; a photoelectric conversion layer disposed between the cathode and the anode; and an electron transport layer disposed between the cathode and the photoelectric conversion layer, the electron transport layer containing titanium oxide and at least one element selected from the group consisting of pentavalent elements and hexavalent elements.

## Description

### TECHNICAL FIELD

The present invention relates to a solar cell capable of exhibiting excellent photoelectric conversion efficiency even when ultraviolet light is blocked.

### BACKGROUND ART

Photoelectric conversion elements have been developed which include a laminated body of a plurality of kinds of semiconductor layers and electrodes disposed on respective sides of the laminated body. Further, instead of such a laminated body, use of a composite film of a plurality of kinds of semiconductors has also been examined. In such photoelectric conversion elements, each semiconductor acts as a P-type semiconductor or an N-type semiconductor. Photocarriers (electron-positive hole pairs) are generated by photoexcitation in the P-type semiconductor or the N-type semiconductor so that electrons and positive holes move through the N-type semiconductor and the P-type semiconductor, respectively, to create an electric field.

Most photoelectric conversion elements for practical use nowadays are inorganic solar cells produced by use of inorganic semiconductors formed of silicon or other materials. However, production of inorganic solar cells is costly, and upsizing is difficult, which limit the usable range of the solar cells. Thus, organic solar cells (for example, Patent Literatures 1 and 2) produced by use of organic semiconductors instead of inorganic semiconductors are attracting interest.

In organic solar cells, an electron transport layer is often disposed between a cathode and a photoelectric conversion layer that contains an N-type semiconductor and a P-type semiconductor. As a material of the electron transport layer, highly photoconductive titanium oxide is frequently used. For example, Patent Literature 3 discloses an organic thin-film solar cell in which an oxide semiconductor layer,'a layer containing an organic semiconductor, a conductive polymer layer, and a collecting electrode layer are stacked on a transparent electrode layer in the stated order, and the oxide semiconductor layer is an amorphous titanium oxide layer. Further, Patent Literature 4 discloses an organic power generating laminated body that includes at least a positive electrode, an organic photoelectric conversion layer, a metal oxide layer, and a negative electrode containing a metal nobler than iron in the stated order. Titanium oxide, zinc oxide, and other oxides are disclosed as preferred metal oxides of the metal oxide layers.

An organic solar cell to be used is sealed between a transparent protective member on the front surface side and a protective member on the back surface side. In order to prevent the degradation of an organic semiconductor and increase the durability of the entire organic solar cell, ultraviolet light is blocked by adding an ultraviolet light absorption material to the transparent protective member or disposing an additional protective layer on the surface of the solar cell.

However, titanium oxide has an absorption wavelength overlapping an ultraviolet region. Therefore, if ultraviolet light to an organic solar cell having an electron transport layer that contains titanium oxide as a raw material is blocked, the photoconductivity of the titanium oxide is reduced, and the function of the electron transport layer is not sufficiently exhibited, resulting in significant reduction in photoelectric conversion efficiency.

### CITATION LIST

### - Patent Literature

Patent Literature 1: JP 2006-344794 A
Patent Literature 2: JP 4120362 B
Patent Literature 3: JP 2009-146981 A
Patent Literature 4: WO 2011/158874

### SUMMARY OF INVENTION

### - Technical Problem

It is an object of the present invention to provide a solar cell capable of exhibiting excellent photoelectric conversion efficiency even when ultraviolet light is blocked.

### - Solution to Problem

The present invention relates to a solar cell including: a cathode; an anode; a photoelectric conversion layer disposed between the cathode and the anode; and an electron transport layer disposed between the cathode and the photoelectric conversion layer, the electron transport layer containing titanium oxide and at least one element selected from the group consisting of pentavalent elements and hexavalent elements.

The present invention is described in detail below.

The present inventors have found that a solar cell including: a cathode; an anode; a photoelectric conversion layer disposed between the cathode and the anode; and an electron transport layer disposed between the cathode and the photoelectric conversion layer, in which the electron transport layer contains titanium oxide and at least one element selected from the group consisting of pentavalent elements and hexavalent elements, can prevent reduction in photoconductivity of the titanium oxide caused when ultraviolet light is blocked, and can have excellent photoelectric conversion efficiency even when ultraviolet light is blocked. Thereby, the present invention has been completed.

The solar cell of the present invention includes a cathode; an anode; a photoelectric conversion layer disposed between the cathode and the anode; and an electron transport layer disposed between the cathode and the photoelectric conversion layer.

A material of the cathode is not particularly limited, and may be a conventionally known material. Examples thereof include sodium, a sodium-potassium alloy, lithium, magnesium, aluminum, a magnesium-silver mixture, a magnesium-indium mixture, an aluminum-lithium alloy, an Al/Al₂O₃ mixture, an Al/LiF mixture, SnO₂, FTO, AZO, IZO, GZO, and ITO. Any of these materials may be used alone, or two or more kinds thereof may be used in combination.

A material of the anode is not particularly limited, and may be a conventionally known material. Examples thereof include metals such as gold, conductive transparent materials such as CuI, ITO (indium tin oxide), SnO₂, AZO, IZO, or GZO, and conductive transparent polymers. Any of these materials may be used alone, or two or more kinds thereof may be used in combination.

The electron transport layer contains titanium oxide and at least one element selected from the group consisting of pentavalent elements and hexavalent elements.

Addition of at least one element selected from the group consisting of pentavalent elements and hexavalent elements to titanium oxide changes the valence of the electron transport layer, thereby suppressing reduction in the photoconductivity of titanium oxide caused when ultraviolet light is blocked. Accordingly, the solar cell of the present invention has excellent photoelectric conversion efficiency even when ultraviolet light is blocked.

Examples of the titanium oxide include, but are not particularly limited to, anatase-type titanium oxide and rutile-type titanium oxide. Any of these titanium oxides may be used alone, or two or more kinds thereof may be used in combination. In particular, anatase-type titanium oxide is preferred because it has lower refractivity than rutile-type titanium oxide.

Examples of the at least one element selected from the group consisting of pentavalent elements and hexavalent elements include, but are not particularly limited to, group 5 elements in the periodic table such as niobium (Nb), vanadium (V), or tantalum (Ta); group 6 elements in the periodic table such as molybdenum (Mo), chromium (Cr), or tungsten (W); phosphorus; and iodine. The at least one element selected from the group consisting of pentavalent elements and hexavalent elements may be used alone, or two or more kinds thereof may be used in combination. That is, the at least one element selected from the group consisting of pentavalent elements and hexavalent elements is preferably one or more elements selected from the group consisting of niobium (Nb), vanadium (V), tantalum (Ta), molybdenum (Mo), chromium (Cr), tungsten (W), phosphorus, and iodine.

In particular, one or more elements selected from the group consisting of niobium (Nb), vanadium (V), tantalum (Ta), molybdenum (Mo), and phosphorus are still more preferred, and niobium (Nb) and tantalum (Ta) are particularly preferred as the use thereof enhances the photoelectric conversion efficiency.

The at least one element selected from the group consisting of pentavalent elements and hexavalent elements may be contained as a simple substance or contained as a compound.

A simple substance of the at least one element selected from the group consisting of pentavalent elements and hexavalent elements is a substance consisting of only one element selected from the group consisting of pentavalent elements and hexavalent elements. The simple substance of the at least one element selected from the group consisting of pentavalent elements and hexavalent elements is preferably a metal of at least one element selected from the group consisting of pentavalent elements and hexavalent elements.

A compound of the at least one element selected from the group consisting of pentavalent elements and hexavalent elements is a substance including two or more elements that include at least one element selected from the group consisting of pentavalent elements and hexavalent elements. The compound of the at least one element selected from the group consisting of pentavalent elements and hexavalent elements is preferably an oxide of at least one element selected from the group consisting of pentavalent elements and hexavalent elements. The oxide of at least one element selected from the group consisting of pentavalent elements and hexavalent elements is not particularly limited. For example, oxides of group 5 elements in the periodic table such as niobium oxide (Nb₂O₅), vanadium oxide (V₂O₅), or tantalum oxide (Ta₂O₅), and oxides of group 6 elements in the periodic table such as molybdenum oxide (MoO₃), chromic oxide (CrO₂), or tungsten oxide (WO₂) are used. In addition, oxides such as tetraphosphorus decoxide (P₄O₁₀) or iodine oxide (I₂O₅) may be used. Any of the oxides of at least one element selected from the group consisting of pentavalent elements and hexavalent elements may be used alone, or two or more kinds thereof may be used in combination. In particular, niobium oxide (Nb₂O₅) and tantalum oxide (Ta₂O₅) are particularly preferred as the use thereof enhances the photoelectric conversion efficiency.

In particular, the electron transport layer preferably contains titanium oxide doped with at least one element selected from the group consisting of pentavalent elements and hexavalent elements as the use thereof more enhances the photoelectric conversion efficiency. The at least one element selected from the group consisting of pentavalent elements and hexavalent elements (dopants) to be added is preferably selected from the above-listed pentavalent elements and hexavalent elements. Specific examples thereof include group 5 elements in the periodic table such as niobium, vanadium, or tantalum; group 6 elements in the periodic table such as molybdenum, chromium, or tungsten; phosphorus; and iodine.

In the electron transport layer, the ratio of titanium to the at least one element selected from the group consisting of pentavalent elements and hexavalent elements is preferably 99.9:0.1 to 50:50 (molar ratio). When the proportion of the at least one element selected from the group consisting of pentavalent elements and hexavalent elements is not less than the lower limit, the effect of changing the valence of the electron transport layer is enhanced, and reduction in the photoelectric conversion efficiency when ultraviolet light is blocked can be further prevented. When the proportion of the at least one element selected from the group consisting of pentavalent elements and hexavalent elements is not more than the upper limit, reduction in the photoelectric conversion efficiency caused by significant changes of inherent electronic properties and optical properties of titanium oxide can be prevented. The ratio of titanium to the at least one element selected from the group consisting of pentavalent elements and hexavalent elements is more preferably 99:1 to 70:30 (molar ratio).

When the electron transport layer contains titanium oxide doped with at least one element selected from the group consisting of pentavalent elements and hexavalent elements, the ratio of titanium to the at least one element selected from the group consisting of pentavalent elements and hexavalent elements is preferably 99.9:0.1 to 60:40 (molar ratio), and more preferably 99.9:0.1 to 90:10 (molar ratio).

Each element content can be determined by, for example, EDS (energy dispersive x-ray spepctroscopy) measurement.

In the electron transport layer, the at least one element selected from the group consisting of pentavalent elements and hexavalent elements may be substantially uniformly dispersed, and may preferably be present more on the cathode side for higher photoelectric conversion efficiency.

Specifically, preferably 90% by weight or more, or more preferably 95% by weight or more of the at least one element selected from the group consisting of pentavalent elements and hexavalent elements contained in the electron transport layer is preferably present within 60% of the depth of the electron transport layer from the cathode side in the thickness direction. Further, preferably 90% by weight or more, or more preferably 95% by weight or more of the at least one element selected from the group consisting of pentavalent elements and hexavalent elements contained in the electron transport layer is preferably present within 30% of the depth of the electron transport layer from the cathode side in the thickness direction.

The electron transport layer may be prepared by any method, and is preferably prepared by a method including forming a coating film using a metal alkoxide solution of at least one element selected from the group consisting of pentavalent elements and hexavalent elements, forming a titanium oxide layer on the surface of the coating film, and sintering these layers, for example, at a temperature of 400 to 600°C for 10 to 60 minutes. According to the method, the electron transport layer including a layer containing an oxide of at least one element selected from the group consisting of pentavalent elements and hexavalent elements; a titanium oxide layer; and a layer, which is created at an interface between these layers, containing titanium oxide and an oxide of at least one element selected from the group consisting of pentavalent elements and hexavalent elements can be formed by sintering. Therefore, reduction in the photoconductivity of the titanium oxide caused by blocking ultraviolet light can be prevented. When the electron transport layer is formed on the cathode by such a method, the oxide of at least one element selected from the group consisting of pentavalent elements and hexavalent elements is present more on the cathode side of the electron transport layer.

The electron transport layer is also preferably prepared by a method including preparing particles of titanium oxide doped with at least one element selected from the group consisting of pentavalent elements and hexavalent elements, forming a coating film using a dispersion of the particles, and sintering the coating film. According to the method, a layer containing titanium oxide doped with at least one element selected from the group consisting of pentavalent elements and hexavalent elements can be formed. Further, a titanium oxide layer may be prepared on the surface of the obtained layer and sintered, thereby forming an electron transport layer containing a titanium oxide layer and a layer containing titanium oxide doped with at least one element selected from the group consisting of pentavalent elements and hexavalent elements. When the electron transport layer is formed on the cathode by such a method, the at least one element selected from the group consisting of pentavalent elements and hexavalent elements is present more on the cathode side of the electron transport layer.

The particles of titanium oxide doped with at least one element selected from the group consisting of pentavalent elements and hexavalent elements may be prepared by any method, and may be prepared, for example, by a method including dropwise addition of nitric acid into a mixture of titanium isopropoxide and a metal alkoxide of at least one element selected from the group consisting of pentavalent elements and hexavalent elements, and heating and stirring the mixture. The average particle size of the particles of titanium oxide doped with at least one element selected from the group consisting of pentavalent elements and hexavalent elements is not particularly limited, and is preferably 5 to 100 nm and more preferably 10 to 60 nm for favorable film forming properties and higher photoelectric conversion efficiency.

The average particle size can be measured by, for example, a dynamic light-scattering method.

The electron transport layer may also be prepared, for example, by a method of forming a layer containing titanium oxide and at least one element selected from the group consisting of pentavalent elements and hexavalent elements by simultaneously sputtering titanium oxide and at least one element selected from the group consisting of pentavalent elements and hexavalent elements, or a method of applying a dispersion of titanium oxide particles and particles of at least one element selected from the group consisting of pentavalent elements and hexavalent elements.

The lower limit of the thickness of the electron transport layer is preferably 1 nm, and the upper limit of the thickness of the electron transport layer is preferably 2,000 nm. The electron transport layer with a thickness of not smaller than 1 nm can more sufficiently block positive holes. The electron transport layer with a thickness of not larger than 2,000 nm tends not to create resistance to electron transport, thus increasing the photoelectric conversion efficiency. The lower limit of the thickness of the electron transport layer is more preferably 3 nm, and the upper limit of the thickness of the electron transport layer is more preferably 1,000 nm. The lower limit of the thickness of the electron transport layer is still more preferably 10 nm, and the upper limit of the thickness of the electron transport layer is still more preferably 600 nm.

The photoelectric conversion layer is not particularly limited as long as it contains an N-type semiconductor and a P-type semiconductor. The N-type semiconductor and the P-type semiconductor may be organic semiconductors or inorganic semiconductors made of a metallic sulfide or a metal oxide.

In particular, the photoelectric conversion layer preferably includes a layer containing an inorganic semiconductor for an increase in durability of a solar cell. The layer containing an inorganic semiconductor is more preferably a layer containing a metallic sulfide. Further, the solar cell of the present invention is more preferably an organic thin-film solar cell having a photoelectric conversion layer that includes a layer containing a metallic sulfide (hereinafter, also referred to as a sulfide layer) and a layer containing an organic semiconductor (hereinafter, also referred to as an organic semiconductor layer). In such a photoelectric conversion layer, it is presumed that the sulfide layer mainly acts as an N-type semiconductor, and the organic semiconductor layer mainly acts as a P-type semiconductor. Meanwhile, the sulfide layer may partially act as a P-type semiconductor, and the organic semiconductor layer may partially act as an N-type semiconductor. The photoelectric conversion layer may be a laminated body including the sulfide layer and the organic semiconductor layer, or a composite film of the sulfide layer and the organic semiconductor layer. The composite film is more preferred as the use thereof can improve the charge separation efficiency of the organic semiconductor.

Examples of the metallic sulfide contained in the sulfide layer include sulfides of group 15 elements in the periodic table (e.g. antimony sulfide, bismuth sulfide, and arsenic sulfide), cadmium sulfide, tin sulfide, indium sulfide, zinc sulfide, iron sulfide, and lead sulfide. In particular, antimony sulfide is preferred. Antimony sulfide is favorably compatible with the organic semiconductor in terms of the energy level. Moreover, it has higher visible light absorption than conventionally used materials such as zinc oxide or titanium oxide. Thus, when antimony sulfide is used as the metal sulfide, the solar cell has higher photoelectric conversion efficiency. Any of these metallic sulfides may be used alone, or two or more kinds thereof may be used in combination.

The metal sulfide contained in the sulfide layer may be a complex sulfide in which two or more kinds of elements are present in a molecule.

The sulfide layer may contain, in addition to the metal sulfide as a main component, other elements that do not impair the effects of the present invention. Such other elements are not particularly limited, but are preferably any of elements in periods 4 to 6 in the periodic table. Specific examples thereof include indium, gallium, tin, cadmium, copper, zinc, aluminum, nickel, silver, titanium, vanadium, niobium, molybdenum, tantalum, iron, and cobalt. Any of these other elements may be used alone, or two or more kinds thereof may be used in combination. Indium, gallium, tin, cadmium, zinc, and copper are particularly preferred as the use thereof enhances the electron mobility.

The amount of other elements is preferably 50% by weight at the maximum in the sulfide layer. The sulfide layer containing 50% by weight or less of other elements does not have a negative influence on the compatibility between the sulfide layer and the organic semiconductor, and the photoelectric conversion efficiency is not reduced.

The sulfide layer is preferably a crystalline semiconductor. When the sulfide layer is a crystalline semiconductor, the electron mobility is enhanced, thus increasing the photoelectric conversion efficiency.

The crystalline semiconductor means a semiconductor whose scattering peaks can be detected by X-ray diffraction measurement or other techniques.

The degree of crystallization may be employed as an index of the crystallinity of the sulfide layer. The lower limit of the degree of crystallization of the sulfide layer is preferably 30%. When the degree of crystallization is not less than 30%, the electron mobility is enhanced, thus increasing the photoelectric conversion efficiency. The lower limit of the degree of crystallization is more preferably 50%, and still more preferably 70%.

The degree of crystallization can be determined as follows: scattering peaks of a crystalline fraction detected by X-ray diffraction measurement or other techniques and halo due to an amorphous fraction are separated by fitting; integrated intensities thereof are determined; and the proportion of the crystalline fraction in the whole is calculated.

In order to increase the degree of crystallization of the sulfide layer, the sulfide layer may be subjected to, for example, thermal annealing, exposure to strong light such as laser or flash lamp, exposure to excimer light, or exposure to plasma. Exposure to strong light or exposure to plasma, for example, is particularly preferred as such a technique can suppress oxidation of the metal sulfide.

Examples of the organic semiconductor contained in the organic semiconductor layer include, but are not particularly limited to, compounds having a thiophene structure such as poly(3-alkyl thiophene). Further, conductive polymers having, for example, a polyparaphenylene vinylene structure, a polyvinyl carbazole structure, a polyaniline structure, or a polyacetylene structure may be used. Further, compounds having, for example, a phthalocyanine structure, a naphthalocyanine structure, a pentacene structure, or a porphyrin structure such as a benzoporphyrin structure may be used. In particular, compounds having a thiophene structure, a phthalocyanine structure, a naphthalocyanine structure, or a benzoporphyrin structure are preferred because of their relatively high durability.

The organic semiconductor contained in the organic semiconductor layer is also preferably a donor-acceptor type semiconductor, which can absorb light in the long-wavelength region. In particular, donor-acceptor compounds having a thiophene structure are more preferred. Among the donor-acceptor compounds having a thiophene structure, a thiophene-diketopyrrolopyrrole polymer is particularly preferred in terms of the light-absorption wavelength.

In cases where the photoelectric conversion layer is a laminated body, the lower limit of the thickness of the sulfide layer is preferably 5 nm, and the upper limit of the thickness of the sulfide layer is preferably 5,000 nm. The sulfide layer with a thickness of not smaller than 5 nm can sufficiently absorb light, thus increasing the photoelectric conversion efficiency. The sulfide layer with a thickness of not larger than 5,000 nm prevents generation of regions where charge separation does not occur, thus preventing a reduction in the photoelectric conversion efficiency. The lower limit of the thickness of the sulfide layer is more preferably 10 nm, and the upper limit of the thickness of the sulfide layer is more preferably 1,000 nm. The lower limit of the thickness of the sulfide layer is still more preferably 20 nm, and the upper limit of the thickness of the sulfide layer is still more preferably 500 nm.

In cases where the photoelectric conversion layer is a laminated body, the lower limit of the thickness of the organic semiconductor layer is preferably 5 nm, and the upper limit of the thickness of the organic semiconductor layer is preferably 1,000 nm. The organic semiconductor layer with a thickness of not smaller than 5 nm can sufficiently absorb light, thus increasing the photoelectric conversion efficiency. The organic semiconductor layer with a thickness of not larger than 1,000 nm prevents generation of regions where charge separation does not occur, thus preventing a reduction in the photoelectric conversion efficiency. The lower limit of the thickness of the organic semiconductor layer is more preferably 10 nm, and the upper limit of the thickness of the organic semiconductor layer is more preferably 500 nm. The lower limit of the thickness of the organic semiconductor layer is still more preferably 20 nm, and the upper limit of the thickness of the organic semiconductor layer is still more preferably 200 nm.

In cases where the photoelectric conversion layer is a composite film, the ratio of the sulfide layer to the organic semiconductor layer is very important. The ratio (volume ratio) of the sulfide layer to the organic semiconductor layer is preferably 1:19 to 19:1. If the ratio is within the above range, positive holes or electrons easily reach the electrodes, thus increasing the photoelectric conversion efficiency. The ratio (volume ratio) is more preferably 1:9 to 9:1.

The lower limit of the thickness of the composite film is preferably 30 nm, and the upper limit of the thickness of the composite film is preferably 3,000 nm. The composite film with a thickness of not smaller than 30 nm can more sufficiently absorb light, thus increasing the photoelectric conversion efficiency. The composite film with a thickness of not larger than 3,000 nm enables electric charge to be easily transferred to the electrodes, thus increasing the photoelectric conversion efficiency. The lower limit of the thickness of the composite film is more preferably 40 nm, and the upper limit of the thickness of the composite film is more preferably 1,000 nm. The lower limit of the thickness of the composite film is still more preferably 50 nm, and the upper limit of the thickness of the composite film is still more preferably 500 nm.

The solar cell of the present invention may further include a positive hole transport layer between the photoelectric conversion layer and the anode.

The materials of the positive hole transport layer are not particularly limited. Examples of the materials include P-type conductive polymers, P-type low molecular weight organic semiconductors, P-type metal oxides, P-type metal sulfides, and surfactants. Specific examples thereof include a polystyrenesulfonic acid adduct of polyethylenedioxythiophene, carboxyl group-containing polythiophene, phthalocyanine, porphyrin, molybdenum oxide, vanadium oxide, tungsten oxide, nickel oxide, copper oxide, tin oxide, molybdenum sulfide, tungsten sulfide, copper sulfide, tin sulfide or the like, fluoro group-containing phosphonic acid, and carbonyl group-containing phosphonic acid.

The lower limit of the thickness of the positive hole transport layer is preferably 1 nm, and the upper limit of the thickness of the positive hole transport layer is preferably 2,000 nm. The positive hole transport layer with a thickness of not smaller than 1 nm can sufficiently block electrons. The positive hole transport layer with a thickness of not larger than 2,000 nm tends not to create resistance to positive hole transport, thus increasing the photoelectric conversion efficiency. The lower limit of the thickness of the positive hole transport layer is more preferably 3 nm, and the upper limit of the thickness of the positive hole transport layer is more preferably 1,000 nm. The lower limit of the thickness of the positive hole transport layer is still more preferably 5 nm, the upper limit of the thickness of the positive hole transport layer is still more preferably 500 nm.

The solar cell of the present invention may be produced by any method, and is for example produced by a method including forming an electrode (anode) on a substrate; forming a positive hole transport layer on the surface of the electrode (anode), if necessary; forming a photoelectric conversion layer on the surface of the positive hole transport layer by printing such as spin coating or vacuum evaporation; forming an electron transport layer on the surface of the photoelectric conversion layer by the above method; and forming an electrode (cathode) on the surface of the electron transport layer. Alternatively, after the electrode (cathode) is formed on a substrate, the electron transport layer, the photoelectric conversion layer, the positive hole transport layer, and the electrode (anode) may be formed in the stated order.

Since the solar cell of the present invention has high photoelectric conversion efficiency even when ultraviolet light is blocked, the solar cell is preferably used in a state where ultraviolet light is blocked. Specifically, ultraviolet light is preferably blocked, for example, in such a way that when the solar cell of the present invention is disposed between a transparent protective member and a protective member for a back face, and is integrated therewith using a sealant to be formed into a stacked module, an ultraviolet light absorption layer is preferably formed on the surface, or an ultraviolet light absorption material is preferably added to the transparent protective member or the sealant.

By blocking ultraviolet light, the organic semiconductor is prevented from deterioration, thus enhancing the durability of the solar cell.

### - Advantageous Effects of Invention

The present invention can provide a solar cell capable of exhibiting excellent photoelectric conversion efficiency even when ultraviolet light is blocked.

### DESCRIPTION OF EMBODIMENTS

The present invention is described in more detail below referring to, but not limited to, examples.

### (Example 1)

An ethanol solution of niobium ethoxide was applied to the surface of an ITO film as a transparent electrode (cathode) by spin coating, and dried to form a coating film with a thickness of 10 nm. On the surface of the coating film was formed a 0.4-µm thick titanium oxide layer (anatase titanium oxide, average particle size 16 nm) by spin coating. The resulting product was sintered at 400°C in the atmosphere for 10 minutes. In this manner, an electron transport layer containing titanium oxide and niobium oxide (valence 5) was formed.

Then, antimony sulfide was deposited on the surface of the electron transport layer by evaporation, and sintered at 250°C under low pressure for 10 minutes. P3HT (a conjugated polymer having a thiophene structure that contains a hexyl group at position 3) was applied to the surface of the resulting antimony sulfide layer by spin coating. Thus, a photoelectric conversion layer was formed. Then, PEDOT:PSS was applied on the surface of the photoelectric conversion layer to form a positive hole transport layer. Further, gold was deposited on the surface of the positive hole transport layer as a metal electrode (anode) by evaporation. In this manner, a solar cell was obtained.

### (Example 2)

A solar cell was obtained in the same manner as in Example 1 except that cadmium sulfide was used instead of antimony sulfide.

### (Example 3)

A solar cell was obtained in the same manner as in Example 1 except that zinc oxide was used instead of antimony sulfide.

### (Example 4)

A solar cell was obtained in the same manner as in Example 1 except that a fullerene derivative PCBM was used instead of antimony sulfide.

### (Example 5)

A solar cell was obtained in the same manner as in Example 1 except that tantalum ethoxide was used instead of niobium ethoxide.

### (Example 6)

A solar cell was obtained in the same manner as in Example 1 except that vanadium ethoxide was used instead of niobium ethoxide.

### (Example 7)

A solar cell was obtained in the same manner as in Example 1 except that phosphorus oxide was used instead of niobium ethoxide.

### (Example 8)

A solar cell was obtained in the same manner as in Example 1 except that a molybdenum oxide layer was formed by spin coating instead of applying an ethanol solution of niobium ethoxide by spin coating.

### (Comparative Example 1)

A solar cell was obtained in the same manner as in Example 1 except that an ethanol solution of niobium ethoxide was not applied.

### (Comparative Example 2)

A solar cell was obtained in the same manner as in Example 2 except that an ethanol solution of niobium ethoxide was not applied.

### (Comparative Example 3)

A solar cell was obtained in the same manner as in Example 3 except that an ethanol solution of niobium ethoxide was not applied.

### (Comparative Example 4)

A solar cell was obtained in the same manner as in Example 4 except that an ethanol solution of niobium ethoxide was not applied.

### (Comparative Example 5)

A solar cell was obtained in the same manner as in Example 1 except that zirconium butoxide was used instead of niobium ethoxide.

### (Comparative Example 6)

A solar cell was obtained in the same manner as in Example 1 except that aluminum butoxide was used instead of niobium ethoxide.

### (Comparative Example 7)

A solar cell was obtained in the same manner as in Example 1 except that magnesium ethoxide was used instead of niobium ethoxide.

### (Example 9)

### (Preparation of niobium-doped titanium oxide particles)

A mixture of 3 g of titanium isopropoxide and 0.1 g of niobium ethoxide was prepared. To the mixture was added dropwise 20 mL of 0.1 M nitric acid, and then the mixture was stirred at 80°C for 8 hours. After stirring, the resulting solid product was washed with pure water. In this manner, niobium-doped titanium oxide particles (particles of titanium oxide doped with niobium, Ti:Nb = 30:1, average particle size 10 nm) were prepared.

### (Production of solar cell)

An ethanol dispersion of niobium-doped titanium oxide particles was applied to the surface of an FTO film as a transparent electrode (cathode) by spin coating, and dried to form a coating film with a thickness of 60 nm. The resulting product was sintered at 600°C in the atmosphere for 30 minutes. On the surface of the coating film was formed a 0.2-µm thick titanium oxide layer (anatase titanium oxide, average particle size 16 nm) by spin coating, and the resulting product was sintered at 400°C in the atmosphere for 10 minutes. In this manner, an electron transport layer including a layer that contains titanium oxide doped with niobium (valence 5) and a titanium oxide layer was formed.

Then, antimony sulfide was deposited on the surface of the electron transport layer by evaporation, and sintered at 250°C under low pressure for 10 minutes. P3HT (a conjugated polymer having a thiophene structure that contains a hexyl group at position 3) was applied to the surface of the resulting antimony sulfide layer by spin coating to form a photoelectric conversion layer. Then, PEDOT:PSS was applied on the surface of the photoelectric conversion layer to form a positive hole transport layer. Further, gold was deposited on the surface of the positive hole transport layer by evaporation as a metal electrode (anode). In this manner, a solar cell was obtained.

### (Example 10)

A solar cell was obtained in the same manner as in Example 9 except that the thickness of the dried coating film formed using niobium-doped titanium oxide particles (Ti:Nb = 30:1) was 100 nm, and the thickness of the titanium oxide layer (anatase titanium oxide, average particle size 16 nm) formed on the surface of the coating film was 100 nm.

### (Example 11)

Tantalum-doped titanium oxide particles (particles of titanium oxide doped with tantalum, Ti:Ta = 30:1, average particle size 10 nm) were prepared in the same manner as in Example 9 except that tantalum ethoxide was used instead of niobium ethoxide. A solar cell was obtained in the same manner as in Example 9 except that tantalum-doped titanium oxide particles were used instead of niobium-doped titanium oxide particles.

### (Example 12)

An ethanol dispersion of the niobium-doped titanium oxide particles obtained in Example 9 was applied to the surface of an FTO film as a transparent electrode (cathode) by spin coating to form a deposition with a thickness of 0.2 µm. The resulting product was sintered at 600°C in the atmosphere for 30 minutes. In this manner, an electron transport layer containing titanium oxide doped with niobium (valence 5) was formed.

Then, antimony sulfide was deposited on the surface of the electron transport layer by evaporation, and sintered at 250°C under low pressure for 10 minutes. P3HT (a conjugated polymer having a thiophene structure that contains a hexyl group at position 3) was applied to the surface of the resulting antimony sulfide layer by spin coating. Thus, a photoelectric conversion layer was formed. Then, PEDOT:PSS was applied on the surface of the photoelectric conversion layer to form a positive hole transport layer. Further, gold was deposited on the surface of the positive hole transport layer as a metal electrode (anode) by evaporation. In this manner, a solar cell was obtained.

### (Example 13)

A solar cell was obtained in the same manner as in Example 12 except that the tantalum-doped titanium oxide particles obtained in Example 11 were used instead of the niobium-doped titanium oxide particles.

### (Example 14)

Niobium-doped titanium oxide particles (particles of titanium oxide doped with niobium, Ti:Nb = 900:1, average particle size 16 nm) were prepared in the same manner as in Example 9 except that the feed amount of niobium ethoxide was changed. A solar cell was obtained in the same manner as in Example 12 except that the resulting niobium-doped titanium oxide particles were used.

### (Example 15)

Niobium-doped titanium oxide particles (particles of titanium oxide doped with niobium, Ti:Nb = 2:1, average particle size 12 nm) were prepared in the same manner as in Example 9 except that the feed amount of niobium ethoxide was changed. A solar cell was obtained in the same manner as in Example 12 except that the resulting niobium-doped titanium oxide particles were used.

### (Example 16)

Niobium-doped titanium oxide particles (particles of titanium oxide doped with niobium, Ti:Nb = 10:1, average particle size 16 nm) were prepared in the same manner as in Example 9 except that the feed amount of niobium ethoxide was changed. A solar cell was obtained in the same manner as in Example 12 except that the resulting niobium-doped titanium oxide particles were used.

### <Evaluation>

The solar cells obtained in the examples and the comparative examples were evaluated according to the following criteria. Tables 1 and 2 show the results.

### (1) Measurement of photoelectric conversion efficiency

Current density-voltage characteristics of each solar cell were measured using a solar cell characteristic evaluation system CEP-015 (produced by Bunkoukeiki Co., Ltd.) under AM 1.5 (100 mW/cm²) of artificial sunlight irradiation. Thus, photoelectric conversion efficiency was determined. Evaluation was performed according to the following criteria.

Good (o): Photoelectric conversion efficiency of 0.7 or higher based on the photoelectric conversion efficiency of the solar cell obtained in Comparative Example 1 taken as 1

Fair (Δ): Photoelectric conversion efficiency of 0.3 or higher and lower than 0.7 based on the photoelectric conversion efficiency of the solar cell obtained in Comparative Example 1 taken as 1

Poor (x): Photoelectric conversion efficiency of lower than 0.3 based on the photoelectric conversion efficiency of the solar cell obtained in Comparative

### Example 1 taken as 1

### (2) Change rate of photoelectric conversion efficiency when ultraviolet light is blocked

Current density-voltage characteristics of each solar cell were measured in the same manner as in the measurement (1) in a state where 400 nm or less of wavelengths were blocked using a film containing an ultraviolet light absorption material, thereby determining photoelectric conversion efficiency. The change rate (after light is blocked/before light is blocked) of photoelectric conversion efficiency was determined from the photoelectric conversion efficiencies before and after 400 nm or less of wavelengths were blocked.

### (3) Durability evaluation

After each solar cell was sealed with glass, and allowed to stand at a temperature of 60°C and a humidity of 30% for 72 hours, the current density-voltage characteristics of the solar cell were measured in the same manner as in the measurement (1). Thus, the photoelectric conversion efficiency was determined. Evaluation was performed according to the following criteria.

Good (○): 80% or higher of the initial photoelectric conversion efficiency was kept even after 72 hours have passed.

Fair (Δ): 40% to 80% (not including 80%) of the initial photoelectric conversion efficiency was kept even after 72 hours have passed.

Poor (×): Only lower than 40% of the initial photoelectric conversion efficiency was kept after 72 hours have passed.

### (4) Comprehensive evaluation

Evaluation was performed according to the following criteria.

Excellent (oo): The change rate of the photoelectric conversion efficiency when ultraviolet light was blocked was 0.7 or higher, and both the photoelectric conversion efficiency and the durability were evaluated as "o".

Good (o): The change rate of the photoelectric conversion efficiency when ultraviolet light was blocked was 0.7 or higher, and the photoelectric conversion efficiency was evaluated as "Δ" and the durability was evaluated as "o".

Fair (Δ): The change rate of the photoelectric conversion efficiency when ultraviolet light was blocked was 0.7 or higher, and both the photoelectric conversion efficiency and the durability were evaluated as "Δ".

Poor (x): The change rate of the photoelectric conversion efficiency when ultraviolet light was blocked was lower than 0.7.

**[Table 1]**

| | | Example 1 | Example 2 | Example 3 | Example 4 | Example 5 | Example 6 | Example 7 | Example 8 | Comparative Example 1 | Comparative Examples 2 | Comparative Example 3 | Comparative Example 4 | Comparative Example 5 | Comparative Example 6 | Comparative Example 7 |
|---|---|---|---|---|---|---|---|---|---|---|---|---|---|---|---|---|
| Electron transport layer | | TiO₂ | TiO₂ | TiO₂ | TiO₂ | TiO₂ | TiO₂ | TiO₂ | TiO₂ | TiO₂ | TiO₂ | TiO₂ | TiO₂ | TiO₂ | TiO₂ | TiO₂ |
| | | Nb₂O₅ (valence 5) | Nb₂O₅ (valence 5) | Nb₂O₅ (valence 5) | Nb₂O₅ (valence: 5) | Ta₂O₅ (valence: 5) | V₂O₅ (valence 5) | P₄O₁₀ (valence: 5) | MoO₃ (valence: 6) | - | - | - | - | ZrO₂ (valence: 4) | Al₂O₃ (valence 3) | MgO (valence 2) |
| Photoelectric conversion layer | N-type semiconductor | Sb₂S₃ | CdS | ZnO | Fullerene derivative PCBM | Sb₂S₃ | Sb₂S₃ | Sb₂S₃ | Sb₂S₃ | Sb₂S₃ | CdS | ZnO | Fullerene derivative PCBM | Sb₂S₃ | Sb₂S₃ | Sb₂S₃ |
| | P-type semiconductor | P3HT | P3HT | P3HT | P3HT | P3HT | P3HT | P3HT | P3HT | P3HT | P3HT | P3HT | P3HT | P3HT | P3HT | P3HT |
| Evaluation | Photoelectric conversion efficiency | ○ | ○ | Δ | Δ | ○ | Δ | ○ | Δ | ○ | ○ | ○ | Δ | ○ | ○ | Δ |
| | Rate of change of photoelectric conversion efficiency when UV light is blocked | 0.74 | 0.72 | 0.72 | 0.71 | 0.75 | 0.73 | 0.74 | 0.7 | 0.54 | 0.5 | 0.52 | 0.46 | 0.55 | 0.5 | 0.32 |
| | Durability | ○ | ○ | ○ | Δ | ○ | ○ | ○ | ○ | Δ | ○ | ○ | Δ | ○ | ○ | ○ |
| | Comprehensive evaluation | ○○ | ○○ | ○ | Δ | ○○ | ○ | ○○ | ○ | × | × | × | × | × | × | × |

**[Table 2]**

| | | Example 9 | Example 10 | Example 11 | Example 12 | Example 13 | Example 14 | Example 15 | Example 16 |
|---|---|---|---|---|---|---|---|---|---|
| Electron transport layer | | TiO₂ | TiO₂ | TiO₂ | - | - | - | - | - |
| | | TiO₂ doped with Nb (valence: 5) | TiO₂ doped with Nb (valence: 5) | TiO₂ doped with Ta (valence: 5) | TiO₂ doped with Nb (valence: 5) | TiO₂ doped with Ta (valence: 5) | TiO₂ doped with Nb (valence: 5) | TiO₂ doped with Nb (valence: 5) | TiO₂ doped with Nb (valence: 5) |
| Photoelectric conversion layer | N-type semiconductor | Sb₂S₃ | Sb₂S₃ | Sb₂S₃ | Sb₂S₃ | Sb₂S₃ | Sb₂S₃ | Sb₂S₃ | Sb₂S₃ |
| | P-type semiconductor | P3HT | P3HT | P3HT | P3HT | P3HT | P3HT | P3HT | P3HT |
| Evaluation | Photoelectric conversion efficiency | ○ | Δ | ○ | ○ | ○ | ○ | Δ | ○ |
| | Change rate of photoelectric conversion efficiency when UV light is blocked | 0.92 | 0.86 | 0.9 | 0.85 | 0.84 | 0.7 | 0.8 | 0.82 |
| | Durability | ○ | ○ | ○ | ○ | ○ | ○ | ○ | ○ |
| | Comprehensive evaluation | ○○ | ○ | ○○ | ○○ | ○○ | ○○ | ○ | ○○ |

### INDUSTRIAL APPLICABILITY

The present invention can provide a solar cell capable of exhibiting excellent photoelectric conversion efficiency even when ultraviolet light is blocked.

## Claims

1. A solar cell comprising:
a cathode;
an anode;
a photoelectric conversion layer disposed between the cathode and the anode; and
an electron transport layer disposed between the cathode and the photoelectric conversion layer,
the electron transport layer containing titanium oxide and at least one element selected from the group consisting of pentavalent elements and hexavalent elements.

2. The solar cell according to claim 1,
wherein the electron transport layer contains titanium oxide and an oxide of at least one element selected from the group consisting of pentavalent elements and hexavalent elements.

3. The solar cell according to claim 1,
wherein the electron transport layer contains titanium oxide doped with at least one element selected from the group consisting of pentavalent elements and hexavalent elements.

4. The solar cell according to claim 1, 2, or 3,
wherein the at least one element selected from the group consisting of pentavalent elements and hexavalent elements is one or more elements selected from the group consisting of niobium, vanadium, tantalum, molybdenum, chromium, tungsten, phosphorus, and iodine.

5. The solar cell according to claim 1, 2, 3, or 4,
wherein the photoelectric conversion layer includes a layer containing an inorganic semiconductor.

6. The solar cell according to claim 5,
wherein the layer containing an inorganic semiconductor is a layer containing a metallic sulfide.

7. The solar cell according to claim 1, 2, 3, 4, 5, or 6,
wherein the photoelectric conversion layer includes a layer containing an organic semiconductor.
